**Europäisches Patentamt**

**European Patent Office**

**Office européen des brevets**

(11) Veröffentlichungsnummer: **0 520 077 A1**

# EUROPÄISCHE PATENTANMELDUNG

(21) Anmeldenummer: **91110424.8**

(22) Anmeldetag: **24.06.91**

(51) Int. Cl.5: **H03K 21/12**, H03K 21/02

(43) Veröffentlichungstag der Anmeldung:
**30.12.92 Patentblatt 92/53**

(84) Benannte Vertragsstaaten:
**AT DE FR GB IT**

(71) Anmelder: **SIEMENS AKTIENGESELLSCHAFT**
**Wittelsbacherplatz 2**
**W-8000 München 2(DE)**

(72) Erfinder: **Brune, Richard, Dipl.-Ing.**
**Sonneberger Strasse 38**
**W-8510 Fürth(DE)**

(54) **Digitale Zählschaltung zur Auswertung eines digitalen Eingangssignals mit beliebigem Puls-Pausenverhältnis.**

(57) Mit der digitalen Zählschaltung läßt sich ein digitales Eingangssignal (S), daß ein beliebiges Puls-Pausenverhältnis aufweisen kann, unter Verwendung eines herkömmlichen digitalen Zählers (Z) auswerten. Zur sicheren Auswertung wird das Eingangssignal (S) über einen Frequenzteiler (FT) geteilt, so daß das Ausgangssignal (S/2) des Frequenzteilers (FT) ein Puls-Pausenverhältnis von 1:1 aufweist. Zur Verdopplung des Zählbereichs gegenüber dem Zählbereich des verwendeten Zählers (Z) wird das Ausgangssignal (S/2) am Zähler (Z) vorbeigeschleift und als "Quasi"-Ausgangssignal (N + 1) zu den Ausgangssignalen (N) des Zählers (Z) verwendet.

FIG 1

EP 0 520 077 A1

Digitale Zähler zur Auswertung von digitalen Signalen sind beispielsweise aus U.Tietze, Ch.Schenk, "Halbleiterschaltungstechnik", 6. Auflage, Springer Verlag Berlin, S. 247 ff bekannt. Diese digitalen Zähler arbeiten gewöhnlich nach dem Prinzip der Frequenzteilung, wobei die Frequenzteilung mit Hilfe von Flip- Flop-Schaltungen realisiert wird. Jeder binäre Ausgang eines Zählers steht dabei in einem festen Teilungsverhältnis zur Frequenz des digitalen Signals, das auf den Zählereingang gegeben wird. Die Frequenz der niederwertigsten Binärstelle ist bei den bekannten Zählern halb so groß wie die Frequenz des digitalen Zählereingangssignals, dessen Pulse gezählt werden. Zur Erhöhung des Zählbereichs muß nach dem Stand der Technik jeweils auf einen Zähler mit mehreren Binärstellen zurückgegriffen werden.

In der älteren europäischen Patentanmeldung (Aktenzeichen 90 108 326.1) wird zur Erhöhung des Zählbereichs eines gegebenen Zählers eine digitale Zählschaltung vorgeschlagen, bei der das digitale Signal, mit dem der Eingang des Zählers beaufschlagt ist, als eine weitere Binärstelle darstellendes Ausgangssignal zu den Ausgangssignalen des Zählers verwendet wird.

Damit läßt sich zwar eine Verdopplung der Zählerauflösung erreichen, die sichere Funktionsweise der Schaltung ist jedoch davon abhängig, daß das Puls-Pausenverhältnis des digitalen Eingangssignals nicht wesentlich von 1:1 abweicht. Da dies in der Praxis jedoch häufig der Fall ist, z.B. dann, wenn das digitale Signal von einem herkömmlichen "Voltage Controlled Oscillator (VCO)" erzeugt wird, ist die vorgeschlagene digitale Zählschaltung nicht immer anwendbar.

Aufgabe der Erfindung ist es daher, eine digitale Zählschaltung zu erhalten, mit der digitale Eingangssignale mit beliebigem Puls-Pausenverhältnis auswertbar sind und bei der der Zählbereich doppelt so groß ist, als der des verwendeten Zählers.

Diese Aufgabe wird mit einer digitalen Zählschaltung zur Auswertung eines digitalen Eingangssignals mit beliebigem Puls-Pausenverhältnis gelöst, die einen Frequenzteiler und eine diesem nachgeschaltete Zählvorrichtung umfaßt, wobei der Frequenzteiler mindestens ein digitales Signal mit mindestens der doppelten Periodendauer des Eingangssignals mit einem Puls-Pausenverhältnis von 1:1 erzeugt und wobei das digitale Signal auf den Eingang der Zählvorrichtung geführt und zugleich als eine erste weitere Binärstelle darstellendes Signal zu den Ausgangssignalen der Zählvorrichtung verwendet wird. Damit ist es möglich, trotz der Frequenzteilung die gleiche Auflösung zu erhalten, die mit einem herkömmlichen digitalen Zähler ohne Frequenzteilung nur dann möglich wäre, wenn das Eingangssignal bereits ein Puls-Pausenverhältnis von 1:1 aufweisen würde. Mit der digitalen Zählschaltung lassen sich auch Eingangssignale von höherer Frequenz erfassen, wenn das Eingangssignal mit einem Frequenzteiler soweit geteilt wird, daß es durch die nachgeschaltete Zählvorrichtung erfaßt werden kann. Allerdings verringert sich in diesem Fall die Auswertegenauigkeit.

Nach einer vorteilhaften Ausbildung der digitalen Zählschaltung wird ein digitales Eingangssignal, daß ein Tastverhältnis von 1:1 aufweist, als eine zweite, weitere Binärstelle darstellendes Ausgangssignal zu den Ausgangssignalen der Zählvorrichtung verwendet. Wenn das Eingangssignal die erwähnte Eigenschaft aufweist, läßt sich damit die Auflösung der Zählschaltung zusätzlich verdoppeln.

Ein Ausführungbeispiel der Erfindung ist in der Zeichnung dargestellt und wird im folgenden näher erläutert. Dabei zeigen:

FIG 1      eine digitale Zählschaltung,
FIG 2      bis FIG 6 Impulsdiagramme,
FIG 7      den Inhalt eines Zählregisters,
FIG 8      eine digitale Zählschaltung mit durchgeschleiftem Eingangssignal.

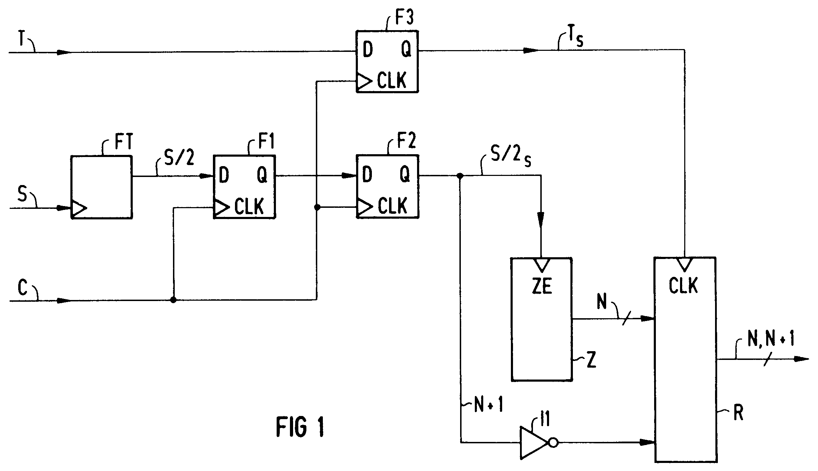

FIG 1 zeigt eine digitale Zählschaltung, die aus einem Frequenzteiler FT drei D-Flip-Flops F1, F2, F3, einem Inverter I1, einem Zähler Z sowie einem Register R besteht. Die Richtung des Signalflusses der untereinander verbundenen Bauteile ist jeweils durch Pfeile dargestellt.

Am Eingang des Frequenzteilers FT liegt ein digitales Signal S an, das ein beliebiges Puls-Pausenverhältnis aufweisen kann. Durch den Frequenzteiler FT wird das Eingangssignal auf ein Signal S/2 mit der jeweils doppelten Periodendauer des Eingangssignals heruntergeteilt. Der Frequenzteiler FT hat gleichzeitig die Eigenschaft, daß das Puls-Pausenverhältnis seines Ausgangssignal S/2 den Wert 1 aufweist. Das Ausgangssignal S/2 des Frequenzteilers FT wird auf den Eingang D des ersten Flip-Flops F1 geführt. An den Takteingang CLK des ersten sowie an den Takteingang CLK des zweiten Flip-Flops F2 wird ein erstes Taktsignal C gegeben. Das erste Taktsignal C erfüllt bezüglich des digitalen Signals S/2 das Abtasttheorem, d.h. die Frequenz des ersten Taktsignals C ist größer als die doppelte maximale Frequenz des digitalen Signals S/2. Durch die beiden in Serie geschalteten D-Flip-Flops F1, F2 und das erste Taktsignal C wird erreicht, daß am Ausgang des zweiten Flip-Flops F2 das digitale Signal S/2 als synchronisiertes Signal $S/2_S$ anliegt, das bedeutet, daß die positive Flanke des synchronen Signals $S/2_S$ einen festen Bezug zur positiven Flanke des ersten Taktsignals C hat.

Das synchrone Signal $S/2_S$ am Ausgang Q des zweiten Flip-Flops F2 wird auf den Zählereingang ZE des Zählers Z gegeben. Der Zähler Z hat eine Auflösung von N-Binärstellen, wobei die niederwertigste Binärstelle, also die N-te Binärstelle der halben Frequenz des synchronen Signals $S/2_S$ entspricht. Zur Erhöhung des Zählbereichs wird deshalb das synchrone Signal $S/2_S$ als N + 1-te Binärstelle des Zählers verwendet. Im vorliegenden Ausführungsbeispiel wird dazu das synchrone Signal $S/2_S$ über den Inverter I1 invertiert und am Zähler vorbeigeführt. Die Invertierung könnte aber auch softwaremäßig erfolgen. Als Zählsignale stehen damit die N-Ausgangssignale des Zählers und als N + 1-tes Signal das invertierte synchrone digitale Signal $S/2_S$ zur Verfügung, wobei das N + 1-te Signal $\overline{S/2_S}$ nunmehr die niederwertigste Binärstelle darstellt.

Die Zählerausgangssignale N, N + 1 werden im Ausführungsbeispiel an ein Datenregister R gegeben, das den Zählerstand zu vorgebbaren Zeitpunkten übernimmt. Zur Vermeidung metastabiler Zustände wird das Datenregister R mit einem synchronen Taktsignal $T_S$ getaktet, wobei das synchrone Taktsignal $T_S$ aus dem zweiten Taktsignal T durch Synchronisation mit dem ersten Taktsignal C über ein drittes Flip-Flop F3, erzeugt wird.

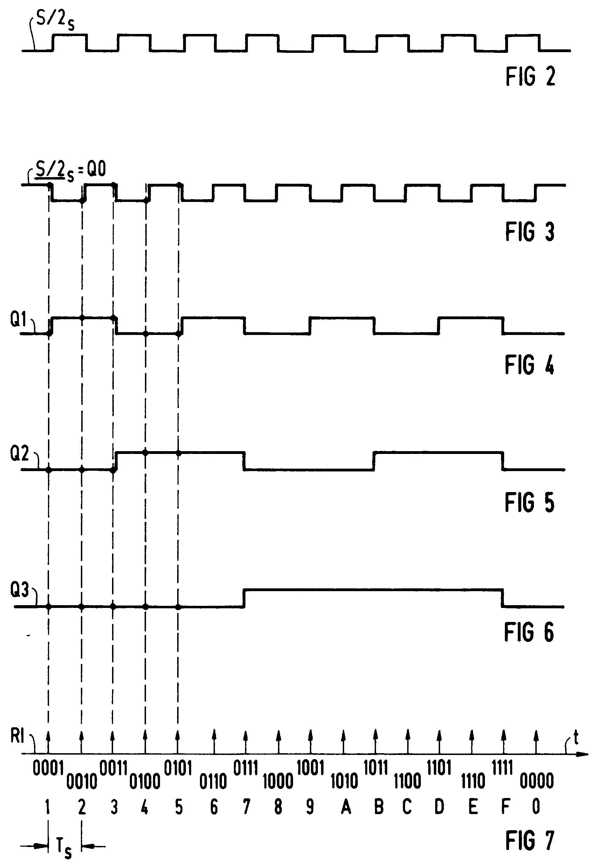

Die Figuren 2 bis 6 zeigen Impulsdiagramme die die Arbeitsweise der Zählschaltung verdeutlichen sollen. In FIG 7 ist der Zeitbezug zu den Impulsdiagrammen dargestellt. Das Impulsdiagramm des synchronisierten Signals $S/2_S$ mit dem der Zählereingang ZE, FIG 1, beaufschlagt wird, ist in FIG 2 dargestellt. Es wird angenommen, daß der aus FIG 1 bekannte Zähler Z über drei binäre Ausgänge Q1, Q2, Q3 verfügt. Die Impulsdiagramme dieser drei binären Zählerausgänge Q1, Q2, Q3 sind in den Figuren 4, 5 und 6 dargestellt. Die höchstwertigste Binärstelle ist am Zählerausgang Q3, die niederwertigste Binärstelle am Zählerausgang Q1 abgreifbar. Mit diesem Zähler könnten lediglich $2^3$ verschiedene Ausgangszustände erreicht, also binär nur bis acht gezählt werden. Wird nun wie in FIG 3 dargestellt, das invertierte, synchronisierte Signal $S/2_S$ als niederwertigstes binäres Ausgangssignal $\overline{Q0}$ zu den Zählerausgangssignalen Q1, Q2, Q3 hinzugenommen, so erhält man vier binäre Ausgangssignale, so daß ein Zählbereich von $2^4$ erreicht wird.

Wenn die binären Signale Q0, Q1, Q2, Q3 in das Register R im vorgegebenen synchronisierten Taktsignal $T_S$ übernommen werden, so ergibt sich der in FIG 7 binär und hexadezimal dargestellte Registerinhalt RI.

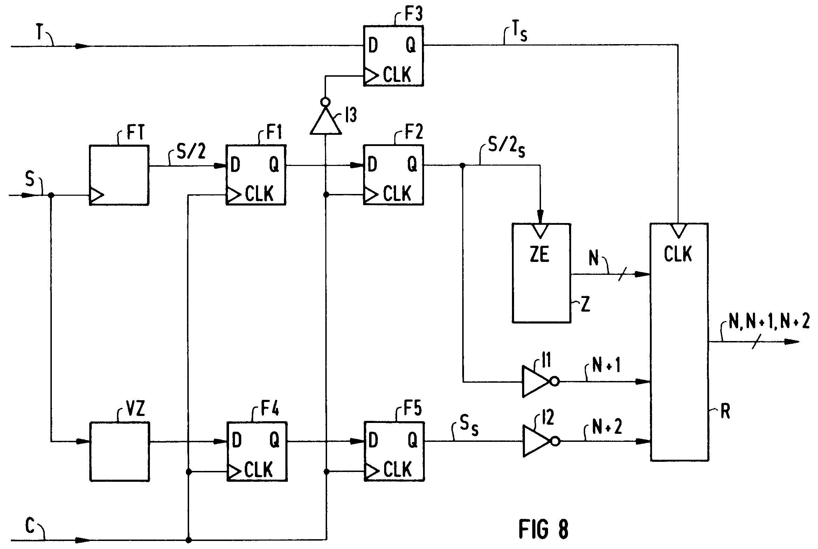

FIG 8 zeigt eine digitale Zählschaltung mit durchgeschleiftem Eingangssignal S. Dabei wird das Eingangssignal S über ein Verzögerungsglied VZ, über ein viertes und fünftes Flip-Flop F4, F5, synchronisiert und als Signal $S_S$ über einen zweiten Inverter I2 ebenfalls am Zähler Z vorbeigeführt und auf das Register R gegeben. Damit steht ein weiteres Signal zur Verfügung, das als N + 2-te Binärstelle zu den Ausgangssignalen N des Zählers Z und zu dem am Zähler Z bereits vorbeigeschleiften synchronisierten Signal $S/2_S$ verwendet wird. Die Auflösung der digitalen Zählschaltung wird damit weiter verdoppelt. Das vierte und fünfte Flip-Flop F4, F5 dienen dabei ebenso wie das erste und zweite Flip-Flop F1, F2 zur Synchronisation des Signals S. Das Verzögerungsglied VZ gleicht die Verzögerung aus, die das Eingangssignal S durch den Frequenzteiler FT erfährt. - Diese Ausführung ist allerdings nur dann zuverlässig einsetzbar, wenn das Puls-Pausenverhältnis des Eingangssignals nicht wesentlich von 1 abweicht.

## Patentansprüche

1. Digitale Zählschaltung zur Auswertung eines digitalen Eingangssignals (S) mit beliebigem Puls-Pausenverhältnis und unterschiedlicher Periodendauer, die einen Frequenzteiler (FT) und eine diesem nachgeschaltete Zählvorrichtung (Z) umfaßt, wobei
   a) der Frequenzteiler (FT) mindestens ein digitales Signal (S/2) mit mindestens der doppelten Periodendauer des Eingangssignals (S) mit einem Puls-Pausenverhältnis von 1:1 erzeugt und wobei
   b) das digitale Signal (S/2) auf den Eingang (ZE) der Zählvorrichtung (Z) geführt und zugleich als eine erste weitere Binärstelle darstellendes Signal (N + 1) zu den Ausgangssignalen (N) der Zählvorrichtung (Z) verwendet wird.

2. Digitale Zählschaltung nach Anspruch 1, wobei ein digitales Eingangssignal (S), das ein Tastverhältnis von 1:1 aufweist, als eine zweite, weitere Binärstelle darstellendes Ausgangssignal (N + 2) zu den Ausgangssignalen (N,N + 1) der Zählvorrichtung (Z) verwendet wird.

FIG 1

FIG 2

FIG 3

FIG 4

FIG 5

FIG 6

FIG 7

FIG 8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PATENT ABSTRACTS OF JAPAN<br>vol. 13, no. 338 (E-795)28. Juli 1989<br>& JP-A-1 099 321 ( FUJITSU ) 18. April 1989<br>* Zusammenfassung *<br>--- | 1,2 | H03K21/12<br>H03K21/02 |
| A | PATENT ABSTRACTS OF JAPAN<br>vol. 8, no. 117 (P-277)(1554) 31. Mai 1984<br>& JP-A-59 024 269 ( NEC HOME ELECTRONICS K.K. )<br>7. Februar 1984<br>* Zusammenfassung *<br>--- | 1,2 | |
| A | NEW ELECTRONICS<br>Bd. 16, Nr. 7, April 1983, LONDEN<br>Seite 19;<br>PANG: 'pulse coincidence unit'<br>* das ganze Dokument * | 1 | |
| | | | RECHERCHIERTE SACHGEBIETE (Int. Cl.5)<br><br>H03K |

Der vorliegende Recherchenbericht wurde für alle Patentansprüche erstellt

| Recherchenort | Abschlußdatum der Recherche | Prüfer |
|---|---|---|
| DEN HAAG | 04 MAERZ 1992 | FEUER F.S. |